# EUROPEAN PATENT SPECIFICATION

(11) **EP 0 458 916 B1**
(45) Date of publication and mention of the grant of the patent: **13.08.1997**
(21) Application number: 90916601.9
(22) Date of filing: 27.09.1990
(51) Int. Cl.: B32B 15/20, C25D 3/56, C25D 11/38

(54) **METHOD AND COMPOSITION FOR DEPOSITING A CHROMIUM-ZINC ANTI-TARNISH COATING ON COPPER FOIL**
VERFAHREN UND ZUSAMMENSETZUNG ZUM BESCHICHTEN EINER KUPFERFOLIE MIT EINER CHROM-ZINK-ANTI-ANLAUF-BESCHICHTUNG
PROCEDE ET COMPOSITION POUR LE REVETEMENT EN CHROME-ZINC ANTITERNISSURE D' UNE FEUILLE DE CUIVRE

(30) Priority: 13.10.1989 US 421475; 02.01.1990 US 459846; 20.09.1990 US 585832
(43) Date of publication of application: 04.12.1991
(73) Proprietor: OLIN CORPORATION, Cheshire, CT 06410-0586 (US)
(72) Inventor: LIN, Lifun, Hamden, CT 06518 (US); CHAO, Chung-Yao, Hamden, CT 06518 (US)
(74) Representative: Klunker . Schmitt-Nilson . Hirsch
(86) International application number: US9005441
(87) International publication number: WO9105658

(56) References cited:
- US-A- 3 106 484
- US-A- 4 387 006
- CHEMICAL ABSTRACTS, vol. 111, no. 8, 21 August 1989, Columbus, Ohio, US; abstract no. 66662j, HUEBNER 'cathodic treatment of copper foils' page 593 ; & DD-A-264 717 8 February 1989
- PATENT ABSTRACTS OF JAPAN vol. 5, no. 156 (C-74)(828) 6 October 1981 & JP-A-56 087 695 (NIPPON KOGYO KK) 16 July 1981
- PATENT ABSTRACTS OF JAPAN vol. 5, no. 156 (C-74)(828) 6 October 1981 & JP-A-56 087 695

## Description

The present invention broadly relates to a method for treating copper and copper base alloy materials to form a tarnish and oxidation resistant film. More particularly, the invention relates to an electrolyte and an electrolytic means for depositing a chromium-zinc film on a copper or copper base alloy foil.

Copper and copper base alloy foils are widely used in the printed circuit board industry. The foil is produced to a thickness of under .15mm (.006 inches) and more generally to a thickness in the range of from about .0005mm (.0002 inches and known in the art as 1/8 ounce foil) to about .71mm (.0028 inches and known in the art as 2 oz. copper foil). The foil is produced by one of two means. "Wrought" foil is produced by mechanically reducing the thickness of a copper or copper alloy strip by a process such as rolling. "Electrodeposited" foil is produced by electrolytically depositing copper ions on a rotating cathode drum and then peeling the deposited strip from the cathode.

The foil is then bonded to a dielectric support layer forming a printed circuit board. The dielectric support layer is typically a polyimide such as Kapton manufactured by DuPont or FR-4 (a fire retardant epoxy). The copper foil layer is laminated to the dielectric carrier layer. Lamination comprises bonding the copper foil layer to the dielectric carrier layer through the use of heat and pressure. A pressure of about 2.07MPa (300 psi) at a temperature at about 175°C for a time of up to 30 minutes will provide suitable adhesion between the layers.

To maximize adhesion, it is desirable to roughen the surface of the foil which contacts the dielectric prior to bonding. While there are a variety of techniques available to roughen or treat the foil, one exemplary technique involves the formation of a plurality of copper or copper oxide dendrites on the foil surface. U.S. Patent Numbers 4,468,293 and 4,515,671, both to Polan et al disclose this treatment. The process produces COPPERBOND® foil (COPPERBOND® is a trademark of Olin Corporation, Stamford, Connecticut).

One problem facing printed circuit board manufacturers using either electrolytic or wrought copper foils is the relative reactivity of the copper. Copper readily stains and tarnishes. Tarnishing may occur during room temperature storage of the foil or during elevated temperature lamination. The stains and tarnish are aesthetically unpleasant and may be a source of problems during the manufacture of the printed circuit board. For example, staining of copper foil prior to lamination can affect both the bond strength between the foil and the dielectric substrate and the etching characteristics of the resultant laminate.

In the past, stain resistance has been imparted to copper and copper base alloy materials by immersion in an electrolyte containing chromate ions. U.S. Patent Number 3,625,844 to McKean, describes a method of stain-proofing copper foil involving the electrolytic treatment of the foil in a aqueous electrolyte under critical conditions of hexavalent chromium ion concentration, cathode current density, and treatment time.

U.S. Patent Number 3,853,716 to Yates et al, discusses the McKean process and points out that it is not a completely satisfactory stain-proofing technique, due to a build-up of copper and chromium cations in the electrolyte bath. The cations interfere with the effectiveness of the stain proofing. Yates et al attempt to overcome this problem by rendering the copper material cathodic as it passes through an aqueous electrolyte containing hexavalent chromium ion containing anions and being of sufficient alkalinity to cause precipitation of copper and chromium cations.

U.S. Patent Number 4,387,006 to Kajiwara et al, discloses coating a copper foil with zinc chromate to prevent a reaction between the hardener added to an epoxy-glass substrate and the foil. The coating is deposited from an aqueous solution containing in excess of 1.0 g/l of both zinc and chromium (VI) ions.

Still other stain proofing techniques are illustrated in United Kingdom published patent applications 2,030,176A and 2,073,779A and U.S. Patent No. 4,131,517 to Mutsuo et al.

Solutions of phosphoric acid, chromic acid and/or their salts have also been applied to various materials in an attempt to impart tarnish and corrosion resistance. U.S. Patent Nos. 3,677,828, 3,716,427 and 3,764,400, all to Caule, illustrate the use of phosphoric acid solutions to improve the tarnish resistance of copper and copper-based alloys. Caule also describes in his '400 patent the use of a caustic rinse solution after application of his phosphoric acid treatment. U.S. Patent Number 4,647,315 to Parthasarathi et al discloses a dilute aqueous chromic acid-phosphoric acid solution.

Phosphoric and/or chromic acid solutions have also been applied to zinc, zinc-coated articles and aluminum foil and articles. U.S. Patent Numbers 2,030,601 to McDonald, 2,412,532 to Tanner, 2,418,608 to Thompson et al, 2,647,865 to Freud and 4,432,846 to Honnycutt, III illustrate some of the applications of phosphoric-chromic acid solution.

Following lamination, the anti-tarnish coating must be removed so the underlying copper foil may be etched into a desired circuit pattern. Circuit traces are patterned into the copper foil by photolithography as known in the art. The unbonded side of the copper foil is coated with a photo-sensitive chemical resist. The resist is exposed to a developer such as ultraviolet light exposed through a mask containing the desired circuit pattern. Dependent on whether the photoresist is that known in the art as "positive" resist or "negative" resist, the image may be either a desired circuit pattern, or the negative image. After exposure, the unexposed portion of the photoresist is removed by rinsing with an appropriate solvent to expose the underlying foil. The circuit board is then immersed in a suitable etchant to remove the exposed copper. After etching and rinsing, the remaining photoresist is removed by a solvent wash. The dielectric substrate is unaffected by the solvent and etchant. The substrate remains intact and the copper foil layer is patterned into a desired configuration of circuit traces.

If the anti-tarnish coating layer is not completely removed, it may interfere with the etching step during photolithography resulting in incomplete etching and the potential for an electrical short circuit. One chemical solution used to remove the anti-tarnish coating comprises 4% by volume, hydrochloric acid in water. Many of the prior art anti-tarnish coatings are not readily removed by the 4% HCl solution and require mechanical abrasion or other invasive techniques. Partial removal of the coating layer or an inordinately long process time may result.

While generally used as the etchant to remove the anti-tarnish coating from copper foil, hydrochloric acid is not desirable for environmental reasons. The chloride ions present are environmentally damaging. Regeneration of the ions into a reusable etchant or the safe disposal of the ions is an expensive proposition. A preferred solution would be to provide an anti-tarnish coating which is readily removed by a less harmful etchant.

It is known in the art that a chromium-zinc compound forms a satisfactory anti-tarnish coating for copper and copper base alloys. One such commercial coating has the composition 10 atomic % Zn; 5% Cr; 37% O; 46% C and 2% Cu. The coating is readily removed with a 4% HCl solution. However, the coating is not removable by other, more preferred etchants such as H₂SO₄.

Accordingly, it is an object of the present invention to provide an electrolytic solution capable of depositing a chromium-zinc compound on the surface of a copper or copper alloy foil. It is a further object of the invention to provide a method for electrolytic deposition such that a high through-put rate and controlled compound composition may be achieved. It is an advantage of the present invention that the coating layer so deposited has good tarnish-resistance to both roughened foil surfaces as well as smooth foil surfaces. It is a further advantage of the invention that the coating layer is readily removed by a 4% HCl solution. Yet another advantage of the invention is the coating layer so produced is readily removed in a dilute sulfuric acid solution. It is a feature of the invention that in one embodiment a caustic rinse solution is provided which further improves the tarnish resistance of the coating when applied to a roughen surface.

In accordance with the present invention, there is a provided an aqueous basic electrolytic solution containing hydroxide ions, from 0.07 to 10 grams per liter of zinc ions, and from 0.1 to 100 grams per liter of a water soluble hexavalent chromium compound. Provided, however, that at least one of the zinc ion or chromium (VI) ion concentration is less than 1.0 g/l. The operating temperature may be from room temperature to about 100°C.

The invention further provides a method for the deposition of a removable anti-tarnish coating from the aqueous electrolyte solution. A copper or copper base alloy foil is immersed in the solution. A current density of from 1 milliamp per square centimeter to 1 amp per square centimeter is applied with the foil serving as the cathode. The foil remains in the electrolyte for a time sufficient to deposit a chromium-zinc coating layer having a thickness effective to prevent tarnish. The strip is then rinsed and dried.

The objects, features and advantages discussed above will become more apparent from the specification and drawing which follow.

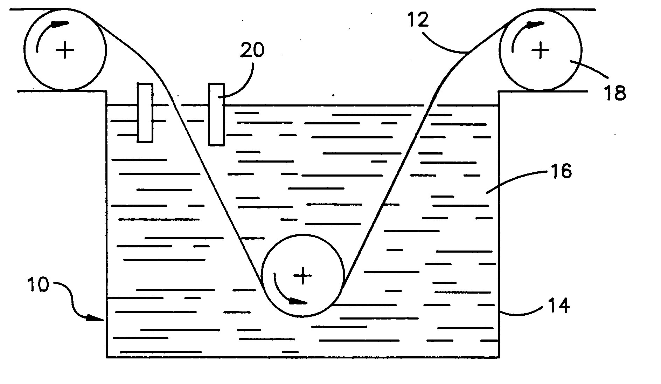

The Figure illustrates an electrolytic cell for depositing a chromium-zinc anti-tarnish coating according to the method of the invention.

The Figure illustrates an electrolytic cell 10 for depositing an anti-tarnish coating on the surface of the copper or copper base alloy foil 12 according to the method of the invention. The electrolytic cell 10 comprises a tank 14 which may be manufactured from any material which does not react with the electrolytic solution 16. An exemplary material for tank 14 is a polymer, such as polyethylene or polypropylene.

Guide rolls 18 control the travel of the foil strip 12 through the electrolytic cell 10. The guide rolls 18 are manufactured from any material which does not react with the electrolyte solution 16. Preferably, at least one of the guide rolls is formed from an electrically conductive material, such as stainless steel, so that a current may be impressed in the copper foil strip as detailed hereinbelow. Guide rolls 18 rotate at a controlled speed so that the foil strip 12 is positioned between anodes 20 for a required time as discussed hereinbelow.

The power source (not shown) is provided so that an electric current may pass from the anodes 20 to the foil strip (cathode) 12 by means of the electrolytic solution 16. In this way, an anti-tarnish coating with the desired composition and thickness is deposited on the foil strip 12.

The electrolytic solution of the invention consists essentially of a hydroxide source, zinc ion source and a water soluble hexavalent chromium. The hydroxide source is preferably sodium hydroxide or potassium hydroxide, and most preferably, sodium hydroxide (NaOH). The hexavalent chromium source may be any water soluble hexavalent chromium compound such as Na₂Cr₂O₇·2H₂O.

In its broadest compositional range, the electrolyte solution 16 consists essentially of from 5 to 100 grams per liter of the hydroxide, from 0.07 up to 10 grams per liter of zinc ions supplied in the form of a water soluble zinc compound such as ZnO and from 0.01 to about 100 grams per liter of a water soluble hexavalent chromium salt. Provided, however, that at least one of the zinc ion or chromium (VI) ion concentrations is less than 1.0 g/l. In a preferred embodiment, the electrolyte contains from 10 to 25 grams per liter NaoH, from .16 to 1.2 gm/l zinc ions, most preferably be in the form of 0.2 to about 1.5 grams per liter ZnO and from .08 to .78 gm/l Cr(VI) ions most preferably be in the form of from 0.2 to 2 grams per liter sodium dichromate.

With each of the solutions described herein above, it is believed that an effective concentration of a surfactant such as lauryl sulfate will provide a more uniform surface.

The pH of the solution is maintained as basic. A pH in the range of from about 12 to 14 is preferred. The solution readily operates at all temperatures from room temperature up to about 100°C. For maximum deposition rates, it is preferred to maintain the electrolyte temperature in the range of about 35°C to about 65°C.

The electrolyte solution operates well in a wide range of current densities. Successful coatings may be applied with a current density ranging from 1 milliamp per square centimeter up to 1 amp per square centimeter. A more preferred current density is from 3 mA/cm² to 100 mA/cm². The actual current density employed is dependent on the time the foil strip 12 is exposed to the current. That is, the time the foil strip 12 is between the anodes 20 and immersed in electrolyte solution 16. Typically, this dwell time is from about 10 to about 25 seconds. During this dwell, an effective thickness of the anti-tarnish coating compound is deposited. The effective thickness is that capable of inhibiting copper tarnish at elevated temperatures of up to 190°C in air for 30 minutes. The anti-tarnish coating should further be sufficiently thin to be easily removable with a 4% HCl etch solution or preferably a 5 wt % H₂SO₄ etch solution. It is believed that an effective coating thickness is from less than 100 angstroms to 0.1 microns. Successful results have been obtained with coating thicknesses as low as 40 angstrom and coating thicknesses of from 10 angstroms to 100 angstroms are preferred. The coating layer is sufficiently thin to appear transparent or impart a slight gray tinge to the copper foil.

The coated foil strip 12 exits the electrolytic cell 10 and excess electrolyte is rinsed from the surfaces of the strip. The rinse solution may comprise deionized water. More preferably, a small quantity of a caustic is added to the deionized water rinse solution. The concentration of caustic is quite low, under 1 percent. Preferably the caustic concentration is from 50 to 150 parts per million. The caustic is selected to be the hydroxide of an alkali metal or the hydroxide of an alkaline earth metal selected from the group consisting of sodium hydroxide, calcium hydroxide, potassium hydroxide and ammonium hydroxide. Most preferred is calcium hydroxide.

A small amount of an organic silane, such as C₈H₂₂N₂O₃Si, on the order of about 1 milliliter per liter may also be added to the rinse solution to maintain peel strength.

After rinsing, the foil strip is dried by forced air. The air may be cool, that is at room temperature or heated. Heated forced air is preferred since accelerated drying minimizes spotting of the foil.

The improvements achieved with anti-tarnish coatings applied by the method of the present invention will be more clearly understood by the examples which follow.

### COMPARATIVE EXAMPLE A

A copper foil produced by electrodeposition was given an anti-tarnish coating. The foil had a smooth surface corresponding to the side of the foil which was in contact with the cathode during electroposition and a rough surface corresponding to the opposite side of the foil.

The foil was coated with a chromium-zinc anti-tarnish coating by immersion in an electrolyte solution containing 100 grams per liter NaOH, 8.5 grams per liter ZnO, and 75 grams per liter Na₂Cr₂O₇·2H₂O. A current density of 5 mA/cm² was impressed on the foil. Dwell time within the anodes was 15 seconds. After coating, the foil was rinsed in distilled water for 15 seconds and dried with forced air.

The coated foil was tested for tarnish resistance. A simulated printed circuit board lamination thermal cycle was employed. The simulation comprised a 30 minute air bake at 190°C. Throughout the examples, the expression "simulated lamination" or equivalent refers to a thermal cycle comprising a 30 minute air bake at 190°C. No discoloration was observed on the shiny side of the foil after the simulation. Extensive discoloration was noted on the rough side of the foil.

The anti-tarnish film was easily removed from both sides of the copper foil with 4% HCl. Total removal of the anti-tarnish film was verified by exposing the foil to (NH₄)₂S fumes. The foil turned blue indicating interaction between the fumes and copper.

### COMPARATIVE EXAMPLE B

A second strip of electrodeposited copper foil was given an anti-tarnish coating. The electrolyte contained 20 grams per liter NaOH, 1.7 grams per liter ZnO, and 15 grams per liter Na₂Cr₂O₇·2H₂O. After coating, the foil was rinsed in distilled water followed by a rinse in distilled water containing 100 parts per million of Ca(OH)₂. The shiny side of the foil exhibited no discoloration following simulated lamination. The anti-tarnish coating was completely removed with immersion in a 4 percent HCl solution.

The roughened side of the electrodeposited foil was not evaluated.

### EXAMPLE C

An electrodeposited copper foil strip was given an anti-tarnish coating according to the method of the invention. The electrolyte solution contained 20 grams per liter NaOH, 0.85 grams per liter ZnO, and 1.5 grams per liter Na₂Cr₂O₇·2H₂O. Following electrolytic deposition, the strip was rinsed in distilled water followed by a rinse in distilled water containing 100 ppm Ca(OH)₂ and 1 milliliter per liter silane. After drying the anti-tarnish coating on the shiny side of the strip was evaluated. No discoloration was detected during simulated lamination and the coating was rapidly removed with 4% HCl. The roughened side of the strip was not evaluated.

### EXAMPLE D

A wrought copper foil having one side roughened with dentritic copper by the COPPERBOND® process was given an anti-tarnish coating according the method of the invention. The electrolyte solution contained 20 grams per liter NaOH, 1 gram per liter ZnO, and 1 gram per liter Na₂Cr₂O₇·2H₂O. The solution temperature was varied between room temperature and 65°C. Following application of the coating, the foil was rinsed in distilled water containing 100 ppm of Ca(OH)₂ heated to a temperature of about 70°C for 25 seconds and then dried by forced air. Various current densities were applied during deposition.

After drying, the coated strip was evaluated for discoloration and ease of removal of the coating as detailed above. At a total electrical charge of about 50 mC/cm² (mC stands for millicoulomb and represents mA x seconds (5mA/cm² x 10 seconds = 50 mC/cm²)), the shiny surface of the wrought foil met all requirements. At a total charge of 70 mC/cm² (7 mA/cm² x 10 seconds), the roughened surface of the wrought foil also passed the evaluation tests.

### EXAMPLE E

Wrought foil with one side roughened as in Example D was coated in solutions containing 20 grams per liter NaOH, 1 gram per liter ZnO, and either 3 grams or 10 grams per liter Na₂Cr₂O₇·2H₂O. Good tarnish resistance as determined by the simulated lamination cycle was achieved on the shiny surface. However, the roughened surface showed marginal tarnish resistance with the coating from the solution containing 3 grams per liter dichromate and no tarnish resistance when coated in the solution containing 10 grams per liter dichromate. As the chromium (VI) ion concentration was increased from .39 g/l (Example D) to 1.18 g/l (Example E) to 3.9 g/l (Example E), the anti-tarnish resistance steadily decreased. At discussed above, at least one of the zinc ion or chromium (VI) ion concentration is maintained below 1.0 g/l.

### EXAMPLE F

Wrought foil having a shiny side and a roughened side as above was coated according to the method of the invention using the solution of Example D. The post plating rinse contained only distilled water. The caustic additive was eliminated. Following the simulated lamination cycle, the shiny surface of the foil had no discoloration, however, the roughened surface was tarnished.

### EXAMPLE G

Wrought foil having a shiny side and a roughened side was coated according to the method of the invention using the solution of Example D. The amperage impressed on the anode 20 facing the shiny side of the foil was 36 amps while the anode facing the roughened side of the foil was 54 amps. The plating time was about 12 seconds.

The coating so produced was readily and rapidly removed in a 5 wt % H₂SO₄ solution. This is an advantage over the commercially available Cr/Zn coating described above which is not removable in a 5 wt % H₂SO₄ etchant.

The composition of the coating layer was determined by Electron Spectroscopy for Chemical Analysis (ESCA) and the shiny side composition was determined to be 5 atomic % Cr; 21% Zn; 56% O; 16% C and 1% Cu. A difference between the coating layer produced by the method of the invention and the commercially available Cr/Zn coating is the ratio of zinc to chromium. While the commercially available coating has a 2:1 ratio, the method of the invention produced a ratio in excess of 4:1 for the conditions of Example G.

The thickness of the coating layer was next determined by Auger Electron Spectroscopy. The technique employs an X-Ray source to sputter away the surface of the sample at a controlled rate, for example, 10 angstroms per minute. The composition of the vaporized material is analyzed. A 50% copper level was considered to indicate the substrate had been reached. The thickness of the coating layer of the invention was determined to be about 40 angstroms as compared to about 80 angstroms for the commercially available material. The satisfactory properties of the anti-tarnish coating of the invention at 40 angstroms indicates a coating thickness in the range of 10 angstroms to 100 angstroms would be sufficient.

Both the commercially available material and the foil coated according to Example G were subjected to the simulated lamination. Higher bake tests at 210°C and 230°C both for 30 minutes in air were also evaluated. As illustrated in Table 1, the coating layer produced by the process of the invention is clearly superior to the commercially available material.

**Table 1**

| Bake Test | Results | |
|---|---|---|
| | Invention Rough/Shiny Side | Commercial Rough/Shiny Side |
| 190° | pass/pass | fail/pass |
| 210° | pass/pass | fail/pass |
| 230° | pass/fail | fail/fail |

From the examples above, it may be seen that an anti-tarnish coating may be applied to a copper or copper based alloy strip by electrolytic deposition. Smooth and shiny surfaces are easily coated. Electrolytic solutions containing a caustic component, zinc oxide and a hexavalent chromium salt within a specified range of compositions are acceptable. Rinsing may be in either distilled water or distilled water containing a caustic additive.

Effective solutions to electrolytically deposit an anti-tarnish coating on a roughened copper or copper base alloy surface are more limited in composition. The chromium (VI) ion concentration should be maintained below about 1.5 grams per liter. Preferably, the chromium (VI) concentration should not exceed about 1.0 grams per liter. Following deposition of the anti-tarnish coating, the coated strip is preferably rinsed in a solution of distilled water containing a small concentration of a caustic.

As discussed above, the addition of an organic additive such as lauryl sulfate to the electrolyte is believed to improve the properties of the anti-tarnish coating. At 30 ppm lauryl sulfate, the oxidation resistance of the coating was found to extend to about 10° higher than a coating deposited from the same electrolyte without the additive. Other properties such as peel strength and acid removability were not affected. The effective composition of the surfactant is believed to be from 10 ppm to 50 ppm.

While not fully understood, the co-electrodeposited anti-tarnish layer is believed to be either an alloy of chromium and zinc or a partial hydroxide compound of those elements or mixtures of such alloys and compounds. It is also believed that the coating includes a higher weight percentage of zinc as compared to chromium.

It is apparent that there has been provided in accordance with this invention electrolytic solutions for depositing a chromium-zinc anti-tarnish coating on copper or a copper based alloy foil as well as a means for the deposition of such a coating which fully satisfy the objects, means, and advantages set forth hereinbefore. While the invention has been described in combination with specific embodiments thereof, it is evident that many alternatives, modifications and variations will be apparent to those skilled in the art in light of the foregoing description. Accordingly, it is intended to embrace all such alternatives, modifications and variations as fall within the scope of the appended claims.

## Claims

1. A basic solution having hydroxide ions for electrolytically depositing an anti-tarnish coating on a copper or copper based alloy foil, characterized by:
from 0.07 grams per liter to 10 grams per liter zinc ions supplied in the form of a water soluble zinc compound;and
from 0.1 grams per liter to 100 grams per liter of chromium (VI) ions in the form of a water soluble hexavalent chromium salt wherein the concentration of either said zinc ions or said chromium (VI) ions or both is less than 1.0 grams per liter.

2. The solution of claim 1 characterized in that said hydroxide ions are supplied in the form of either sodium hydroxide or potassium hydroxide.

3. The solution of claim 2 characterized in that said hydroxide ions are supplied as sodium hydroxide, said zinc ions as zinc oxide and said water soluble hexavalent chromium is selected to be Na₂Cr₂O₇·2H₂O.

4. The solution of claim 3 characterized in that said solution has the composition:
from 10 to 50 grams per liter NaOH;
from 0.16 to 1.2 grams per liter zinc ions; and
from 0.08 to 0.78 grams per liter chromium (VI) ions.

5. The solution of claim 4 characterized in that the composition of said solution is:
from 10 to 25 grams per liter NaOH;
from 0.2 to 1.5 grams per liter ZnO; and
from 0.2 to 2 grams per liter Na₂Cr₂O₇·2H₂O.

6. The solution of claim 5 characterized in that an effective amount of a surfactant is added to said solution.

7. The solution of claim 6 characterized in that said surfactant is lauryl sulfate.

8. The solution of claim 7 characterized in that the concentration of lauryl sulfate is from 10 ppm to 50 ppm.

9. A method for depositing an anti-tarnish coating on a copper or copper base alloy foil strip 12, characterized by the steps of:
providing an electrolytic cell 10 containing an anode 20;
providing said electrolytic cell with basic solution containing hydroxide ions, from 0.07 grams per liter to 10 grams per liter zinc ions supplied in the form of a water soluble zinc compound; and
from 0.1 grams per liter to 100 grams per liter of chromium (VI) ions in the form of a water soluble hexavalent chromium salt wherein the concentration of either said zinc ions or said chromium (VI) ions or both is less than 1.0 grams per liter, providing said foil strip 12 as a cathode; and
electrolytically depositing said chromium and zinc ions on said foil strip 12.

10. The method of claim 9 characterized in that said steps include:
providing an aqueous basic solution containing from 0.07 grams per liter to 7 grams per liter zinc ions;
immersing said foil strip 12 in the electrolyte;
passing current through said strip 12 and electrolyte such that a current density of from 1 milliamp per square centimeter to 1 amp per square centimeter is provided;
electrolytically depositing a chromium-zinc coating on said foil 12 for a time sufficient to deposit a coating having a thickness effective to prevent tarnishing;
removing said strip from said electrolyte;
rinsing said coated strip; and
drying said rinsed coated strip.

11. The method of claim 10 characterized in that the composition of said electrolyte consists essentially of from 10 to 25 grams per liter NaOH, from 0.2 to 1.5 grams per liter ZnO, and from 0.2 to 2 grams per liter Na₂Cr₂O₇·2H₂O.

12. The method of claim 11 characterized in that said solution further includes an effective concentration of a surfactant.

13. The method of claim 12 characterized in that said surfactant is lauryl sulfate.

14. The method of claim 13 characterized in that the pH of said solution is from 12 to 14.

15. The method of claim 14 characterized in that current density for said electrolytic deposition step is from 5 to 100 mA/cm².

16. The method of claims 15 characterized in that the effective thickness of said electrolytically deposited anti-tarnish coating is from less than a hundred angstroms to 0.1 micron.

17. The method of claim 16 characterized in that said rinse step comprises immersion of said coated strip in deionized water.

18. The method of claim 17 characterized in that said deionized water includes an effective amount of a caustic.

19. The method of claim 18 characterized in that the concentration of said caustic is from 50 parts per million to 150 parts per million.

20. The method of claim 19 characterized in that said caustic is selected from the group consisting of sodium hydroxide, calcium hydroxide, potassium hydroxide and ammonium hydroxide.

21. The method of claim 20 characterized in that said caustic is calcium hydroxide.

22. The method of claim 21 characterized in that said rinse solution further contains about 1 milliliter per liter silane.

23. The method of claim 10 characterized in that said foil strip 12 comprises a copper or copper base alloy material having any desired shape or thickness.

24. The method of claim 14 characterized in that the concentration of lauryl sulfate is from 10 ppm to 50 ppm.

25. The method of claim 16 characterized in that the thickness of the electrolytically deposited anti-tarnish coating is from 10 angstroms to 100 angstroms.

26. A copper or copper based alloy material 12 characterized by a coating layer to improve resistance to tarnishing at elevated temperatures wherein said coating layer comprises a co-deposited layer including zinc and chromium with a zinc-to-chromium ratio in excess of 4:1 atomic percent.

27. The copper or copper based alloy material 12 of claim 26 characterized in that said coating layer is co-electrodeposited.

28. The copper or copper based alloy material 12 of claim 26 or 27 characterized in that said copper or copper based alloy material 12 comprises a foil strip.

29. The copper or copper based alloy material 12 of claim 28 characterized in that the thickness of said coating layer is effective to inhibit copper tarnish at temperatures of up to 190°C in air for 30 minutes.

30. The copper or copper based alloy material 12 of claim 29 characterized in that the thickness of said coating layer is from 10 angstroms to 0.1 microns.

31. The copper or copper based alloy material 12 of claim 30 characterized in that the thickness of said coating layer is from 10 angstroms to 100 angstroms.

32. The copper or copper based alloy material 12 of claim 30 characterized in that said foil strip has at least one side roughened with dendritic copper.

33. The coated copper or copper based alloy material 12 of claim 26 or 32 characterized in that said coating layer is deposited from a basic solution 16 having hydroxide ions, from 0.07 grams per liter to 7 grams per liter zinc ions supplied in the form of a water-soluble zinc compound and from 0.1 grams per liter to 100 grams per liter of chromium (VI) ions in the form of a water-soluble hexavalent chromium salt wherein the concentration of either said zinc ions or said chromium (VI) ions or both is less than 1.0 grams per liter.

34. The copper or copper based alloy material 12 of claim 33 characterized in that said solution 16 further includes lauryl sulfate in a concentration of from 10 ppm to 50 ppm.

## Patentansprüche

1. Basische Lösung mit Hydroxid-Ionen zum elektrolytisch Abscheiden einer Anlaufschutz-Beschichtung auf einer Folie aus Kupfer oder aus einer Legierung auf Kupferbasis,
**gekennzeichnet durch:**
0,07 Gramm pro Liter bis 10 Gramm pro Liter Zink-Ionen, die in Form einer wasserlöslichen Zinkverbindung zugeführt werden; und 0,1 Gramm pro Liter bis 100 Gramm pro Liter Chrom (VI)-Ionen in Form eines wasserlöslichen sechswertigen Chromsalzes, wobei die Konzentration der Zink-Ionen oder der Chrom (VI)-Ionen oder von beiden weniger als 1,0 Gramm pro Liter beträgt.

2. Lösung nach Anspruch 1,
**dadurch gekennzeichnet**,
daß die Hydroxid-Ionen entweder in Form von Natriumhydroxid oder von Kaliumhydroxid zugeführt werden.

3. Lösung nach Anspruch 2,
**dadurch gekennzeichnet**,
daß die Hydroxid-Ionen als Natriumhydroxid, die Zink-Ionen als Zinkoxid zugeführt werden und als wasserlösliches sechswertiges Chrom Na₂Cr₂O₇ · 2H₂O gewählt wird.

4. Lösung nach Anspruch 3,
**dadurch gekennzeichnet**,
daß die Lösung die Zusammensetzung hat:
10 bis 50 Gramm pro Liter NaOH;
0,16 bis 1,2 Gramm pro Liter Zink-Ionen; und
0,08 bis 0,78 Gramm pro Liter Chrom (VI)-Ionen.

5. Lösung nach Anspruch 4,
**dadurch gekennzeichnet**,
daß die Zusammensetzung der Lösung ist:
10 bis 25 Gramm pro Liter NaOH;
0,2 bis 1,5 Gramm pro Liter ZnO; und
0,2 bis 2 Gramm pro Liter Na₂Cr₂O₇ · 2H₂O.

6. Lösung nach Anspruch 5,
**dadurch gekennzeichnet**,
daß der Lösung eine wirksame Menge eines oberflächenaktiven Mittels beigegeben ist.

7. Lösung nach Anspruch 6,
**dadurch gekennzeichnet**,
daß das oberflächenaktive Mittel Laurylsulfat ist.

8. Lösung nach Anspruch 7,
**dadurch gekennzeichnet**,
daß die Konzentration an Laurylsulfat 10 ppm bis 50 ppm beträgt.

9. Verfahren zur Abscheidung einer Anlaufschutz-Beschichtung auf einem Folienstreifen (12) aus Kupfer oder aus einer Legierung auf Kupferbasis,
**gekennzeichnet durch**
folgende Schritte:
Bereitstellen einer Elektrolysezelle (10), die eine Anode (20) enthält;
Versehen der Elektrolysezelle mit einer basischen Lösung, die Hydroxid-Ionen, 0,07 Gramm pro Liter bis 10 Gramm pro Liter Zink-Ionen, die in Form einer wasserlöslichen Zinkverbindung zugeführt werden; und 0,1 Gramm pro Liter bis 100 Gramm pro Liter Chrom (VI)-Ionen in Form eines wasserlöslichen sechswertigen Chromsalzes enthält, wobei entweder die Konzentration der Zink-Ionen oder der Chrom (VI)-Ionen oder beider weniger als 1,0 Gramm pro Liter beträgt,
Vorsehen des Folienstreifens (12) als Kathode; und
elektrolytisch Abscheiden der Chrom- und Zink-Ionen auf dem Folienstreifen (12).

10. Verfahren nach Anspruch 9,
**dadurch gekennzeichnet**,
daß die Schritte beinhalten:
Bereitstellen einer wässrigen basischen Lösung, die 0,07 Gramm pro Liter bis 7 Gramm pro Liter Zink-Ionen enthält;
Eintauchen des Folienstreifens (12) in den Elektrolyten;
Leiten von Strom durch den Streifen (12) und den Elektrolyten dergestalt, daß eine Stromdichte von 1 Milliampere pro Quadratzentimer bis 1 Ampere pro Quadratzentimeter herrscht;
elektrolytisch Abscheiden einer Chrom-Zink-Beschichtung auf der Folie (12) für eine Zeit, die zur Abscheidung einer Beschichtung mit einer zum Verhindern von Anlaufen wirksamen Dicke ausreichend ist;
Entfernen des Streifens aus dem Elektrolyten;
Spülen des beschichteten Streifens; und
Trocknen des gespülten beschichteten Streifens.

11. Verfahren nach Anspruch 10,
**dadurch gekennzeichnet**,
daß die Zusammensetzung des Elektrolyten im wesentlichen aus 10 bis 25 Gramm pro Liter NaOH, 0,2 bis 1,5 Gramm pro Liter ZnO und 0,2 bis 2 Gramm pro Liter Na₂Cr₂O₇ · 2H₂O besteht.

12. Verfahren nach Anspruch 11,
**dadurch gekennzeichnet**,
daß die Lösung außerdem eine wirksame Konzentration eines oberflächenaktiven Mittels enthält.

13. Verfahren nach Anspruch 12,
**dadurch gekennzeichnet**,
daß das oberflächenaktive Mittel Laurylsulfat ist.

14. Verfahren nach Anspruch 13,
**dadurch gekennzeichnet**,
daß der pH der Lösung 12 bis 14 beträgt.

15. Verfahren nach Anspruch 14,
**dadurch gekennzeichnet**,
daß die Stromdichte für den Schritt des elektrolytischen Abscheidens 5 bis 100 mA/cm² beträgt.

16. Verfahren nach Anspruch 15,
**dadurch gekennzeichnet**,
daß die wirksame Dicke der elektrolytisch abgeschiedenen Anlaufschutz-Beschichtung von weniger als 100 Angström bis 0,1 µm beträgt.

17. Verfahren nach Anspruch 16,
**dadurch gekennzeichnet**,
daß der Spülschritt ein Eintauchen des beschichteten Streifens in entionisiertes Wasser enthält.

18. Verfahren nach Anspruch 17,
**dadurch gekennzeichnet**,
daß das entionisierte Wasser eine wirksame Menge eines kaustischen Mittels enthält.

19. Verfahren nach Anspruch 18,
**dadurch gekennzeichnet**,
daß die Konzentration des kaustischen Mittels 50 Teile pro Million bis 150 Teile pro Million beträgt.

20. Verfahren nach Anspruch 19,
**dadurch gekennzeichnet**,
daß das kaustische Mittel ausgewählt ist aus der Gruppe, die besteht aus Natriumhydroxid, Kalziumhydroxid, Kaliumhydroxid und Ammoniumhydroxid.

21. Verfahren nach Anspruch 20,
**dadurch gekennzeichnet**,
daß das kaustische Mittel Kalziumhydroxid ist.

22. Verfahren nach Anspruch 21,
**dadurch gekennzeichnet**,
daß die Spüllösung außerdem etwa 1 Milliliter pro Liter Silan enthält.

23. Verfahren nach Anspruch 10,
**dadurch gekennzeichnet**,
daß der Folienstreifen (12) ein Material aus Kupfer oder aus einer Legierung auf Kupferbasis mit irgendeiner gewünschten Form oder Dicke aufweist.

24. Verfahren nach Anspruch 14,
**dadurch gekennzeichnet**,
daß die Konzentration an Laurylsulfat 10 ppm bis 50 ppm beträgt.

25. Verfahren nach Anspruch 16,
**dadurch gekennzeichnet**,
daß die Dicke der elektrolytisch abgeschiedenen Anlaufschutz-Beschichtung 10 Angström bis 100 Angström beträgt.

26. Material (12) aus Kupfer oder aus einer Legierung auf Kupferbasis,
**gekennzeichnet durch**
eine Beschichtungsschicht zur Verbesserung der Beständigkeit gegen Anlaufen bei erhöhten Temperaturen, wobei die Beschichtungsschicht eine gemeinsam abgeschiedene Schicht, die Zink und Chrom mit einem Zink-zu-Chrom-Verhältnis von mehr als 4:1 Atomprozent enthält, aufweist.

27. Material (12) aus Kupfer oder aus einer Legierung auf Kupferbasis nach Anspruch 26,
**dadurch gekennzeichnet**,
daß die Beschichtungsschicht elektrolytisch gemeinsam abgeschieden ist.

28. Material (12) aus Kupfer oder aus einer Legierung auf Kupferbasis nach Anspruch 26 oder 27,
**dadurch gekennzeichnet**,
daß das Material (12) aus Kupfer oder aus einer Legierung auf Kupferbasis einen Folienstreifen aufweist.

29. Material (12) aus Kupfer oder aus einer Legierung auf Kupferbasis nach Anspruch 28,
**dadurch gekennzeichnet**,
daß die Dicke der Beschichtungsschicht wirksam ist zur Hemmung des Anlaufens von Kupfer 30 Minuten lang in Luft bei Temperaturen von bis zu 190°C.

30. Material (12) aus Kupfer oder aus einer Legierung auf Kupferbasis nach Anspruch 29,
**dadurch gekennzeichnet**,
daß die Dicke der Beschichtungsschicht 10 Angström bis 0,1 µm beträgt.

31. Material (12) aus Kupfer oder aus einer Legierung auf Kupferbasis nach Anspruch 30,
**dadurch gekennzeichnet**,
daß die Dicke der Beschichtungsschicht 10 Angström bis 100 Angröm beträgt.

32. Material (12) aus Kupfer oder aus einer Legierung auf Kupferbasis nach Anspruch 30,
**dadurch gekennzeichnet**,
daß bei dem Folienstreifen mindestens eine Seite mit dendritischem Kupfer angerauht ist.

33. Beschichtetes Material (12) aus Kupfer oder aus einer Legierung auf Kupferbasis nach Anspruch 26 oder 32,
**dadurch gekennzeichnet**,
daß die Beschichtungsschicht abgeschieden ist aus einer basischen Lösung (16) mit Hydroxid-Ionen, 0,07 Gramm pro Liter bis 7 Gramm pro Liter Zink-Ionen, die in Form einer wasserlöslichen Zinkverbindung zugeführt wurden, und 0,1 Gramm pro Liter bis 100 Gramm pro Liter Chrom (VI)-Ionen in Form eines wasserlöslichen sechswertigen Chromsalzes, wobei entweder die Konzentration der Zink-Ionen oder der Chrom (VI)-Ionen oder beider weniger als 1,0 Gramm pro Liter beträgt.

34. Material (12) aus Kupfer oder aus einer Legierung auf Kupferbasis nach Anspruch 33,
**dadurch gekennzeichnet**,
daß die Lösung (16) außerdem Laurylsulfat in einer Konzentration von 10 ppm bis 50 ppm enthält.

## Revendications

1. Solution basique ayant des ions hydroxyde pour déposer électrolytiquement un revêtement anti-ternissement sur une feuille de cuivre ou d'alliage à base de cuivre, caractérisée par :
de 0,07 g par litre à 10 g par litre d'ions zinc introduits dans la forme d'un composé de zinc soluble dans l'eau; et
de 0,1 g par litre à 100 g par litre d'ions chrome (VI) dans la forme d'un sel du chrome hexavalent soluble dans l'eau, dans laquelle la concentration soit desdits ions zinc, soit desdits ions chrome (VI), soit des deux est inférieure à 1,0 g par litre.

2. Solution selon la revendication 1, caractérisée en ce que lesdits ions hydroxyde sont introduits dans la forme soit d'hydroxyde de sodium, soit d'hydroxyde de potassium.

3. Solution selon la revendication 2, caractérisée en ce que lesdits ions hydroxydes sont introduits comme hydroxyde de sodium, lesdits ions zinc comme oxyde de zinc et ledit chrome hexavalent soluble dans l'eau est choisi comme étant Na₂Cr₂O₇.2H₂O.

4. Solution selon la revendicatton 3, caractérisée en ce que ladite solution a la composition :
de 10 à 50 g par litre de NaOH;
de 0,16 à 1,2 g par litre d'ions zinc; et
de 0,08 à 0,78 g par litre d'ions chrome (VI).

5. Solution selon la revendication 4, caractérisée en ce que la composition de ladite solution est :
de 10 à 25 g par litre de NaOH;
de 0,2 à 1,5 g par litre de ZnO; et
de 0,2 à 2 g par litre de Na₂Cr₂O₇.2H₂O.

6. Solution selon la revendication 5, caractérisée en ce que l'on ajoute une quantité efficace d'un tensioactif à ladite solution.

7. Solution selon la revendication 6, caractérisée en ce que ledit tensioactif est le sulfate de lauryle.

8. Solution selon la revendication 7, caractérisée en ce que la concentration en sulfate de lauryle est de 10 ppm à 50 ppm.

9. Procédé de dépôt d'un revêtement anti-ternissement sur une bande de feuille de cuivre ou d'alliage à base de cuivre 12, caractérisé par les étapes consistant :
à fournir une cellule électrolytique 10 contenant une anode 20;
à munir ladite cellule électrolytique d'une solution basique contenant des ions hydroxyde, de 0,07 g par litre à 10 g par litre d'ions zinc introduits dans la forme d'un composé de zinc soluble dans l'eau; et de 0,1 g par litre à 100 g par litre d'ions chrome (VI) dans la forme d'un sel du chrome hexavalent soluble dans l'eau, dans laquelle la concentration soit desdits ions zinc, soit desdits ions chrome (VI), soit des deux est inférieure à 1,0 g par litre;
à fournir ladite bande de feuille 12 comme une cathode; et
à déposer électrolytiquement lesdits ions chrome et zinc sur ladite bande de feuille 12.

10. Procédé selon la revendication 9, caractérisée en ce que lesdites étapes consistent :
à fournir une solution aqueuse basique contenant de 0,07 g par litre à 7 g par litre d'ions zinc;
à immerger ladite bande de feuille 12 dans l'électrolyte;
à faire passer du courant à travers ladite bande 12 et l'électrolyte de telle sorte qu'est fournie une densité de courant de 1 milliampère par cm² à 1 ampère par cm²;
à déposer électrolytiquement un revêtement de chrome-zinc sur ladite feuille 12 pendant une durée suffisante pour déposer un revêtement ayant une épaisseur efficace pour éviter le ternissement;
à retirer ladite bande dudit électrolyte;
à rincer ladite bande revêtue; et
à sécher ladite bande revêtue rincée.

11. Procédé selon la revendication 10, caractérisé en ce que la composition dudit électrolyte est essentiellement constituée de 10 à 25 g par litre de NaOH, de 0,2 à 1,5 g par litre de ZnO et de 0,2 à 2 g par litre de Na₂Cr₂O₇.2H₂O.

12. Procédé selon la revendication 11, caractérisé en ce que ladite solution comprend en outre une concentration efficace d'un tensioactif

13. Procédé selon la revendication 12, caractérisé en ce que ledit tensioactif est le sulfate de lauryle.

14. Procédé selon la revendication 13, caractérisé en ce que le pH de ladite solution est de 12 à 14.

15. Procédé selon la revendication 14, caractérisé en ce que la densité de courant pour ladite étape de dépôt électrolytique est de 5 à 100 mA/cm²

16. Procédé selon la revendication 15, caractérisé en ce que l'épaisseur efficace dudit revêtement anti-ternissement électrolytiquement déposé est de moins d'une centaine d'angströms à 0,1 micron.

17. Procédé selon la revendication 16, caractérisé en ce que ladite étape de rinçage comprend l'immersion de ladite bande revêtue dans de l'eau déminéralisée.

18. Procédé selon la revendication 17, caractérisé en ce que ladite eau déminéralisée comprend une quantité efficace d'un caustique.

19. Procédé selon la revendication 18, caractérisé en ce que la concentration dudit caustique est de 50 parties par million à 150 parties par million.

20. Procédé selon la revendication 19, caractérisé en ce que ledit caustique est choisi parmi l'hydroxyde de sodium, l'hydroxyde de calcium, l'hydroxyde de potassium et l'hydroxyde d'ammonium.

21. Procédé selon la revendication 20, caractérisé en ce que ledit caustique est l'hydroxyde de calcium.

22. Procédé selon la revendication 21, caractérisé en ce que ladite solution de rinçage contient en outre environ 1 millilitre par litre de silane.

23. Procédé selon la revendication 10, caractérisé en ce que ladite bande de feuille 12 comprend un matériau de cuivre ou d'alliage à base de cuivre ayant toute forme ou épaisseur souhaitée.

24. Procédé selon la revendication 14, caractérisé en ce que la concentration en sulfate de lauryle est de 10 ppm à 50 ppm.

25. Procédé selon la revendication 16, caractérisé en ce que l'épaisseur du revêtement anti-ternissement déposé par électrolyse est de 10 angströms à 100 angströms.

26. Matériau de cuivre ou d'alliage à base de cuivre 12, caractérisé par une couche de revêtement pour améliorer la résistance au ternissement aux températures élevées, dans lequel ladite couche de revêtement comprend une couche co-déposée incluant du zinc et du chrome avec un rapport zinc à chrome en excès de 4:1% en atome.

27. Matériau de cuivre ou d'alliage à base de cuivre 12 selon la revendication 26, caractérisé en ce que ladite couche de revêtement est co-déposée par électrolyse.

28. Matériau de cuivre ou d'alliage à base de cuivre 12 selon la revendication 26 ou 27, caractérisé en ce que ledit matériau de cuivre ou d'alliage à base de cuivre 12 comprend une bande de feuille.

29. Matériau de cuivre ou d'alliage à base de cuivre 12 selon la revendication 28, caractérisé en ce que l'épaisseur de ladite couche de revêtement est efficace pour inhiber le ternissement du cuivre à des températures allant jusqu'à 190°C dans de l'air pendant 30 minutes.

30. Matériau de cuivre ou d'alliage à base de cuivre 12 selon la revendication 29, caractérisé en ce que l'épaisseur de ladite couche de revêtement est de 10 angströms à 0,1 micron.

31. Matériau de cuivre ou d'alliage à base de cuivre 12 selon la revendication 30, caractérisé en ce que l'épaisseur de ladite couche de revêtement est de 10 angströms à 100 angströms.

32. Matériau de cuivre ou d'alliage à base de cuivre 12 selon la revendication 30, caractérisé en ce que ladite bande de feuille a au moins un côté rendu rugueux avec du cuivre dendritique.

33. Matériau de cuivre ou d'alliage à base de cuivre revêtu 12 selon la revendication 26 ou 32, caractérisé en ce que ladite couche de revêtement est déposée à partir d'une solution basique 16 ayant des ions hydroxyde, de 0,07 g par litre à 7 g par litre d'ions zinc introduits dans la forme d'un composé de zinc soluble dans l'eau et de 0,1 g par litre à 100 g par litre d'ions chrome (VI) dans la forme d'un sel du chrome hexavalent soluble dans l'eau, dans laquelle la concentration soit desdits ions zinc, soit desdits ions chrome (VI), soit des deux est inférieure à 1,0 g par litre.

34. Matériau de cuivre ou d'alliage à base de cuivre 12 selon la revendication 33, caractérisé en ce que ladite solution 16 comprend en outre du sulfate de lauryle dans une concentration de 10 ppm à 50 ppm.
